# EUROPEAN PATENT APPLICATION

(11) **EP 4 503 002 A1**
(43) Date of publication of application: **05.02.2025**
(21) Application number: 23824122.8
(22) Date of filing: 25.05.2023
(51) Int. Cl.: G09G 3/20, H04N 21/422

(54) **DISPLAY DEVICE AND CONTROL METHOD THEREOF**

(30) Priority: 14.06.2022 KR 20220072220
(71) Applicant: Samsung Electronics Co., Ltd., Suwon-si, Gyeonggi-do 16677 (KR)
(72) Inventor: KIM, Sangwon, Suwon-si Gyeonggi-do 16677 (KR); SEO, Jeongryeol, Suwon-si Gyeonggi-do 16677 (KR)
(74) Representative: Appleyard Lees IP LLP
(86) International application number: PCT/KR2023/007181
(87) International publication number: WO 2023/243901

(57) **Abstract**

A display device is disclosed. The display device comprises: a power supply unit; a display; a communication interface which includes circuits; and at least one processor which acquires humidity information of ambient air from a sensor or receives the humidity information from an external device through the communication interface while the display device is in a standby mode, and if the humidity of ambient air is identified as being equal to or greater than a threshold value on the basis of the acquired humidity information, switches the display device from the standby mode to a dehumidification mode.

## Description

### [BACKGROUND OF THE INVENTION]

### [FIELD OF THE INVENTION]

The disclosure relates to a display device and a control method thereof, and more particularly, to a display device that operates by using humidity information, and a control method thereof.

### [DESCRIPTION OF THE RELATED ART]

Recently, there is a trend that display devices in various forms are being developed and distributed.

When various components (e.g., light emitting diodes, etc.) provided in a display device are exposed to a hot and humid environment for a long time, there is a risk that the components may be damaged.

Accordingly, there is a trend that a method for enabling a display device to provide a dehumidification mode by itself, and minimizing a problem that damage occurs when components exposed to a hot and humid environment for a long time operate is being studied and developed.

However, in case a display device executes a dehumidification mode, operations of the components (e.g., light emission of the light emitting diodes) are required as a prior step to execution of the dehumidification mode, and accordingly, there is a problem that the components are damaged.

Accordingly, there has been a demand for a method for executing a dehumidification mode while minimizing the operations of components provided in a display device.

### [DETAILED DESCRIPTION OF THE INVENTION]

### [TECHNICAL SOLUTION]

The disclosure is for addressing the aforementioned need, and the purpose of the disclosure is in providing a display device that operates based on humidity information of the ambient air of the display device, and a control method thereof.

According to an embodiment of the disclosure for achieving the aforementioned purpose, a display device includes a power supply, a display, a communication interface including circuitry, and at least one processor configured to obtain humidity information of ambient air from a sensor, or receive the humidity information from an external device through the communication interface while the display device is in a standby mode, and based on identifying that the humidity of the ambient air is greater than or equal to a threshold value on the basis of the obtained humidity information, switch the display device from the standby mode to a dehumidification mode, wherein the at least one processor is configured to, based on the display device being switched to the dehumidification mode, control the power supply to supply power to the display, and control the display to sequentially display each of a plurality of predetermined images during a specific time.

Here, the at least one processor may include a main processor and a sub processor, and the sub processor may receive power through the power supply in the standby mode, and based on identifying that the humidity of the ambient air is greater than or equal to the threshold value, switch the display device to the dehumidification mode, and the main processor may, based on the display device being switched from the standby mode or the dehumidification mode to a general mode, receive power through the power supply, and control the display to display a screen corresponding to an image signal received through the communication interface.

Also, the at least one processor may, based on receiving a control instruction from a remote control device through the communication interface while the display device is in the standby mode, switch the display device from the standby mode to the dehumidification mode according to the control instruction.

Here, the control instruction may be a control instruction received from the remote control device as at least two buttons among a plurality of buttons provided on the remote control device are pushed.

Also, the at least one processor may obtain humidity information while the display device is in the dehumidification mode, and based on identifying that the humidity of the ambient air is smaller than the threshold value on the basis of the humidity information obtained while the display device is in the dehumidification mode, control the power supply such that power is not supplied to the display by switching the display device from the dehumidification mode to the standby mode.

In addition, the at least one processor may, based on the standby mode of the display device being maintained for greater than or equal to a threshold time, switch the display device from the standby mode to the dehumidification mode.

Further, the sensor may include any one of a humidity detection sensor provided in the display device or a humidity detection sensor provided in the external device.

Also, the at least one processor may, based on receiving a control instruction for switching the display device to a general mode from a remote control device through the communication interface while the display displays the plurality of predetermined images in the dehumidification mode, switch the display device from the dehumidification mode to the general mode.

In addition, each of the plurality of predetermined images may be an image wherein at least one of a pattern of the image, luminance of the image, or a color of the image is different, and the at least one processor may control the display to sequentially display each of the plurality of predetermined images during the specific time such that the luminance of a screen displayed by the display gradually increases.

Further, the display may include a plurality of display modules, and a first display module among the plurality of display modules may include a first communication interface and a first power supply, and a second display module among the plurality of display modules may include a second communication interface and a second power supply. In addition, the at least one processor may, based on the display device being switched to the dehumidification mode, control the first power supply to supply power to the first display module by transmitting a control signal for switching the first display module to the dehumidification mode to the first communication interface, and control the second power supply to supply power to the second display module by transmitting a control signal for switching the second display module to the dehumidification mode to the second communication interface.

According to an embodiment of the disclosure for achieving the aforementioned purpose, a control method of a display device includes the steps of obtaining humidity information of ambient air from a sensor while the display device is in a standby mode, and based on identifying that the humidity of the ambient air is greater than or equal to a threshold value on the basis of the obtained humidity information, switching the display device from the standby mode to a dehumidification mode, and the switching step includes the steps of, based on the display device being switched to the dehumidification mode, supplying power to a display provided in the display device, and controlling the display to sequentially display each of a plurality of predetermined images during a specific time.

Here, the display device may include a main processor and a sub processor, and the switching step may include the step of, based on the sub processor supplied with power in the standby mode identifying that the humidity of the ambient air is greater than or equal to a threshold value, switching the display device from the standby mode to the dehumidification mode, and the control method may further include the steps of, based on the display device being switched from the standby mode or the dehumidification mode to a general mode, the main processor being supplied with power, and the main processor controlling the display to display a screen corresponding to a received image signal.

Also, the switching step may include the step of, based on receiving a control instruction from a remote control device while the display device is in the standby mode, switching the display device from the standby mode to the dehumidification mode according to the control instruction.

Here, the control instruction may be a control instruction received from the remote control device as at least two buttons among a plurality of buttons provided on the remote control device are pushed.

Also, the control method may further include the steps of obtaining humidity information while the display device is in the dehumidification mode, and based on identifying that the humidity of the ambient air is smaller than the threshold value on the basis of the humidity information obtained while the display device is in the dehumidification mode, controlling such that power is not supplied to the display by switching the display device from the dehumidification mode to the standby mode.

Here, the control method may further include the step of, based on the standby mode of the display device being maintained for greater than or equal to a threshold time, switching the display device from the standby mode to the dehumidification mode.

Also, the sensor may include any one of a humidity detection sensor provided in the display device or a humidity detection sensor provided in the external device.

In addition, the control method may further include the step of, based on receiving a control instruction for switching the display device to a general mode from a remote control device while the display displays the plurality of predetermined images in the dehumidification mode, switching the display device from the dehumidification mode to the general mode.

Further, each of the plurality of predetermined images may be an image wherein at least one of a pattern of the image, luminance of the image, or a color of the image is different, and the switching step may include the step of controlling the display to sequentially display each of the plurality of predetermined images during the specific time such that the luminance of a screen displayed by the display gradually increases.

Also, the display may include a plurality of display modules, and a first display module among the plurality of display modules may include a first communication interface and a first power supply, and a second display module among the plurality of display modules may include a second communication interface and a second power supply. In addition, the switching step may include the steps of, based on the display device being switched to the dehumidification mode, controlling the first power supply to supply power to the first display module by transmitting a control signal for switching the first display module to the dehumidification mode to the first communication interface, and controlling the second power supply to supply power to the second display module by transmitting a control signal for switching the second display module to the dehumidification mode to the second communication interface.

According to the various embodiments of the disclosure, a display device can execute a dehumidification mode without going through a step of executing a general mode.

Also, a display device consisting of a plurality of display modules can prevent damage to light emitting diodes provided in the display device by switching each of the plurality of display modules to a dehumidification mode in a dehumidification mode.

### [BRIEF DESCRIPTION OF THE DRAWINGS]

FIG. 1 is a diagram for illustrating a display device according to an embodiment of the disclosure;
FIG. 2 is a block diagram for illustrating a configuration of a display device according to an embodiment of the disclosure;
FIG. 3 is a diagram for illustrating a standby mode according to an embodiment of the disclosure;
FIG. 4 is a diagram for illustrating a dehumidification mode according to an embodiment of the disclosure;
FIG. 5 is a diagram for illustrating a plurality of predetermined images according to an embodiment of the disclosure;
FIG. 6 is a diagram for illustrating a general mode according to an embodiment of the disclosure;
FIG. 7 is a diagram for illustrating a dehumidification mode according to another embodiment of the disclosure;
FIG. 8 is a diagram for illustrating a control instruction according to an embodiment of the disclosure;
FIG. 9 is a diagram for illustrating an OSD menu according to an embodiment of the disclosure; and
FIG. 10 is a flow chart for illustrating a control method of a display device according to an embodiment of the disclosure.

### [MODE FOR IMPLEMENTING THE INVENTION]

First, terms used in this specification will be described briefly, and then the disclosure will be described in detail.

As terms used in the embodiments of the disclosure, general terms that are currently used widely were selected as far as possible, in consideration of the functions described in the disclosure. However, the terms may vary depending on the intention of those skilled in the art who work in the pertinent field, previous court decisions, or emergence of new technologies, etc. Also, in particular cases, there may be terms that were designated by the applicant on his own, and in such cases, the meaning of the terms will be described in detail in the relevant descriptions in the disclosure. Accordingly, the terms used in the disclosure should be defined based on the meaning of the terms and the overall content of the disclosure, but not just based on the names of the terms.

Also, various modifications may be made to the embodiments of the disclosure, and there may be various types of embodiments. Accordingly, specific embodiments will be illustrated in drawings, and the embodiments will be described in detail in the detailed description. However, it should be noted that the various embodiments are not for limiting the scope of the disclosure to a specific embodiment, but they should be interpreted to include all modifications, equivalents, or alternatives of the embodiments included in the ideas and the technical scopes disclosed herein. Meanwhile, in case it is determined that in describing embodiments, detailed explanation of related known technologies may unnecessarily confuse the gist of the disclosure, the detailed explanation will be omitted.

In addition, terms such as "first," "second," etc. may be used to describe various elements, but the terms are not intended to limit the elements. Such terms are used only to distinguish one element from another element.

Further, singular expressions include plural expressions, as long as they do not obviously mean differently in the context. In addition, in the disclosure, terms such as "include" and "consist of' should be construed as designating that there are such characteristics, numbers, steps, operations, elements, components, or a combination thereof described in the specification, but not as excluding in advance the existence or possibility of adding one or more of other characteristics, numbers, steps, operations, elements, components, or a combination thereof.

Also, in the disclosure, "a module" or "a unit" performs at least one function or operation, and may be implemented as hardware or software, or as a combination of hardware and software. In addition, a plurality of "modules" or "units" may be integrated into at least one module and implemented as at least one processor (not shown), except "a module" or "a unit" that needs to be implemented as specific hardware.

Hereinafter, an embodiment of the disclosure will be described in detail with reference to the accompanying drawings, such that a person having ordinary knowledge in the technical field to which the disclosure pertains can easily carry out the embodiment. However, the disclosure may be implemented in several different forms, and is not limited to an embodiment described herein. Also, in the drawings, parts that are not related to explanation of the disclosure were omitted, for explaining the disclosure clearly, and throughout the specification, similar components were designated by similar reference numerals.

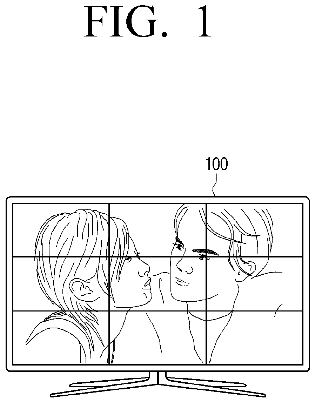

FIG. 1 is a diagram for illustrating a display device according to an embodiment of the disclosure.

Referring to FIG. 1, a display device 100 may display a screen corresponding to an image signal.

According to an embodiment, the display device 100 may be implemented as a TV, but is not limited thereto, and any device can be applied without limitation if it is a device equipped with a display function such as a video wall, a large format display (LFD), digital signage, a digital information display (DID), a projector display, etc. Also, the display device 100 may be implemented as displays in various forms such as a liquid crystal display (LCD), organic light emitting diodes (OLEDs), Liquid Crystal on Silicon (LCoS), Digital Light Processing (DLP), a quantum dot (QD) display panel, quantum dot light emitting diodes (QLEDs), etc.

According to an embodiment, the display device 100 may be implemented in a form of including a plurality of display modules.

For example, as illustrated in FIG. 1, a plurality of display modules may be combined and implement one display device 100 (i.e., a display system). Each of the plurality of display modules according to an embodiment of the disclosure may include a plurality of self-luminous diodes. Here, the self-luminous diodes may be at least one of light emitting diodes (LEDs) or micro LEDs.

Also, each of the plurality of display modules may be implemented as an LED cabinet including a plurality of light emitting diodes (LEDs). Here, the LEDs may be implemented as RGB LEDs, and the RGB LEDs may include red LEDs, green LEDs, and blue LEDs. Also, the LEDs may additionally include white LEDs other than the RGB LEDs.

According to an embodiment, the LEDs may be implemented as micro LEDs. Here, the micro LEDs are LEDs having a size of about 5 - 100 micrometers, and are micro-mini LEDs that emit lights by themselves without a color filter.

According to an embodiment, in case the display device 100 is exposed to a hot and humid environment for a long time, there is a risk that the LEDs provided in the display device 100 may be damaged.

For example, if an unintended high current is applied to the LEDs that were exposed to a hot and humid environment for a long time as the display device 100 displays a screen of high luminance, a metal migration phenomenon (e.g., a metal migration phenomenon between an anode and a cathode) may occur in the LEDs. That is, physical damage may occur in the LEDs.

The display device 100 according to an embodiment of the disclosure can provide various methods for executing a dehumidification mode such that defects are not generated in the LEDs that were exposed to a hot and humid environment for a long time, without applying a high current to the LEDs.

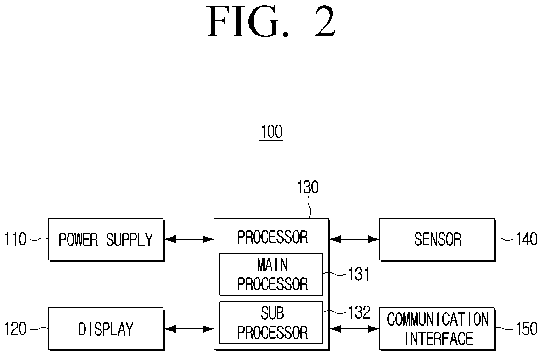

FIG. 2 is a block diagram for illustrating a configuration of a display device according to an embodiment of the disclosure.

According to FIG. 2, the display device 100 includes a power supply 110, a display 120, at least one processor 130, a sensor 140, and a communication interface 150.

The display device 100 may include a power supply 110 for supplying power to the components provided in the display device 100 (e.g., the display 120, the processor 130, the sensor 140, and the communication interface 150, etc.).

The power supply 110 according to an embodiment is hardware that converts an alternating current into a direct current and provides the current, such that it can be used stably in the display 120, etc.

The power supply 110 may largely consist of an AC-DC rectifier, a DC-DC switching converter, an output filter, and an outputter. The power supply 110 may be implemented as, for example, a switched mode power supply (SMPS). The SMPS is a DC stabilization power device that stabilizes an output by controlling an on-off time ratio of a semiconductor switching element, and has a characteristic that high efficiency, miniaturization, and weight lightening are possible.

Meanwhile, the power supply 110 according to an embodiment of the disclosure can obviously include an input electromagnetic interference (EMI) filter unit, etc. As an example, the power supply 110 can remove electric noises of a commercial power through an EMI filter unit.

The display 120 according to an embodiment of the disclosure may be implemented as displays in various forms such as a liquid crystal display (LCD), organic light emitting diodes (OLEDs), Liquid Crystal on Silicon (LCoS), Digital Light Processing (DLP), a quantum dot (QD) display panel, quantum dot light emitting diodes (QLEDs), micro light emitting diodes (µLEDs), mini LEDs, etc. Meanwhile, the display 120 may also be implemented as a touch screen combined with a touch sensor, a flexible display, a rollable display, a 3D display, a display in which a plurality of display modules are physically connected, etc. As described above, the display 120 may consist of a plurality of display modules.

The processor 130 according to an embodiment of the disclosure is electrically connected with the memory (not shown), and controls the overall operations of the display device 100.

According to an embodiment of the disclosure, the processor 130 may be implemented as a digital signal processor (DSP) processing digital signals, a microprocessor, and a timing controller (TCON). However, the disclosure is not limited thereto, and the processor 130 may include one or more of a central processing unit (CPU), a micro controller unit (MCU), a micro processing unit (MPU), a controller, an application processor (AP) or a communication processor (CP), an ARM processor, and an artificial intelligence (AI) processor, or may be defined by the terms.

Also, the processor 130 may be implemented as a system on chip (SoC) having a processing algorithm stored therein or large scale integration (LSI), or implemented in the form of a field programmable gate array (FPGA). The processor 130 may perform various functions by executing computer executable instructions stored in the memory.

The processor 130 according to an embodiment of the disclosure may obtain humidity information of the ambient air from the sensor 140 while the display device 100 is in the standby mode. Here, the sensor 140 may include a humidity detection sensor provided in the display device 100.

The sensor 140 according to an embodiment may sense information on the ambient air. Here, the information on the ambient air is information on the air around the location wherein the display device 100 is arranged, and it may be various kinds of information such as the temperature, the relative humidity, and the wind volume, etc., but is not limited thereto. The sensor 140 may be provided on the exterior of the display device 100, but it may also be provided on the inside. The display device 100 may include only one sensor 140, but may also include a plurality of sensors 140 according to the purpose of sensing.

For example, it is obvious that the sensor 140 can integrally or individually include a temperature detection sensor that obtains temperature information of the ambient air, a humidity detection sensor that obtains humidity information of the ambient air, a wind volume detection sensor that obtains wind volume information of the ambient air, etc.

For the convenience of explanation, FIG. 2 was illustrated based on the assumption of a case wherein the display device 100 includes the sensor 140, but the disclosure is not limited thereto, and the display device 100 can obviously obtain humidity information of the ambient air from the humidity detection sensor provided on an external device (not shown).

As another example, the display device 100 can obviously perform communication with an external device through the communication interface 150, and receive humidity information of the ambient air from the external device. For example, the humidity detection sensor provided on an external device may obtain the humidity information of the ambient air, and the external device may transmit the humidity information to the display device 100.

Then, if it is identified that the humidity of the ambient air is greater than or equal to a threshold value based on the humidity information, the processor 130 may switch the display device 100 from the standby mode to the dehumidification mode.

If the display device 100 is switched to the dehumidification mode, the processor 130 according to an embodiment may control the power supply 110 to supply power to the display 120. Then, the processor 130 may control the display 120 to sequentially display each of a plurality of predetermined images during a specific time.

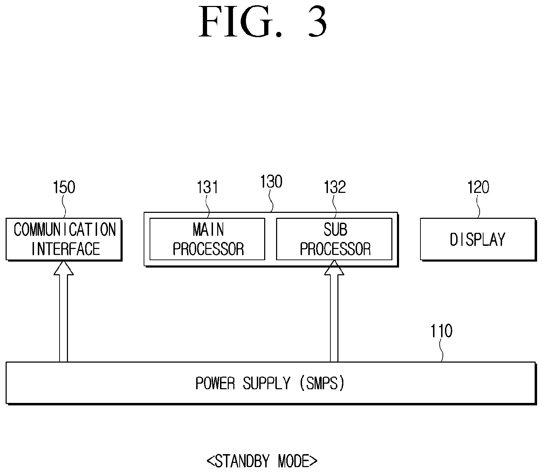

The standby mode according to an embodiment of the disclosure will be explained with reference to FIG. 3.

FIG. 3 is a diagram for illustrating a standby mode according to an embodiment of the disclosure.

Referring to FIG. 3, the processor 130 according to an embodiment of the disclosure may include a main processor 131 and a sub processor 132.

Here, if the display device 100 is in the general mode, the main processor 131 may receive power from the power supply 110, and control the overall operations of the display device 100.

If the display device 100 is in the standby mode or the dehumidification mode, the sub processor 132 according to an embodiment may receive power from the power supply 110.

For example, if the display device 100 is in the standby mode or the dehumidification mode, the main processor 131 may not receive power from the power supply 110 (i.e., an OFF state), but if the display device 100 is in the general mode, the main processor 131 may receive power from the power supply 110 (i.e., an ON state). In contrast, the sub processor 132 may receive power from the power supply 110 if the display device 100 is in the standby mode, the dehumidification mode, or the general mode (i.e., an always ON state).

The processor 130 according to an embodiment may integrally or individually include the main processor 131 and the sub processor 132.

For example, the main processor 131 may mean a high performance processor of which power consumption is relatively high, and the sub processor 132 may mean a low performance processor of which power consumption is relatively low.

The main processor 131 according to an embodiment may include one or more of a central processing unit (CPU), a micro controller unit (MCU), a micro processing unit (MPU), a controller, an application processor (AP), or a communication processor (CP), an ARM processor, and an artificial intelligence (AI) processor, or may be defined by the terms.

The sub processor 132 according to an embodiment may include one or more of a Micom Controller (Micom), a digital signal processor (DSP) processing digital signals, a microprocessor, a timing controller (TCON), or a micro controller unit (MCU), or may be defined by the terms. However, this is merely an example, and the disclosure is obviously not limited thereto. For example, the processor 130 can obviously have a big.LITTLE structure, and include low performance cores (LITTLEs) of which power consumption is relatively low (i.e., the sub processor 132), and high performance processor cores (bigs) of which power consumption is relatively high (i.e., the main processor 131).

The sub processor 132 according to an embodiment may receive humidity information from the sensor 140 while the display device 100 is in the standby mode.

Meanwhile, although not illustrated in FIG. 3, the power supply 110 can obviously supply power to the sensor 140 in the standby mode of the display device 100.

As another example, the sub processor 132 can obviously receive humidity information from an external device through the communication interface 150 while the display device 100 is in the standby mode. In this case, the power supply 110 can obviously supply power to the communication interface 150 in the standby mode of the display device 100.

Then, if it is identified that the humidity of the ambient air is greater than or equal to the threshold value based on the humidity information, the sub processor 132 may switch the display device 100 from the standby mode to the dehumidification mode.

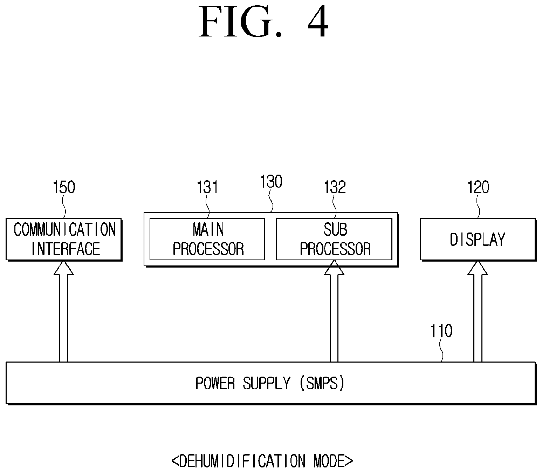

The dehumidification mode according to an embodiment of the disclosure will be explained with reference to FIG. 4.

FIG. 4 is a diagram for illustrating a dehumidification mode according to an embodiment of the disclosure.

When the display device 100 is switched to the dehumidification mode, the sub processor 132 according to an embodiment of the disclosure may control the power supply 110 to supply power to the display 120.

Accordingly, the power supply 110 may supply power to the sub processor 132 and the display 120 in the dehumidification mode of the display device 100.

Then, the sub processor 132 may control the display 120 to sequentially display each of the plurality of predetermined images during a specific time.

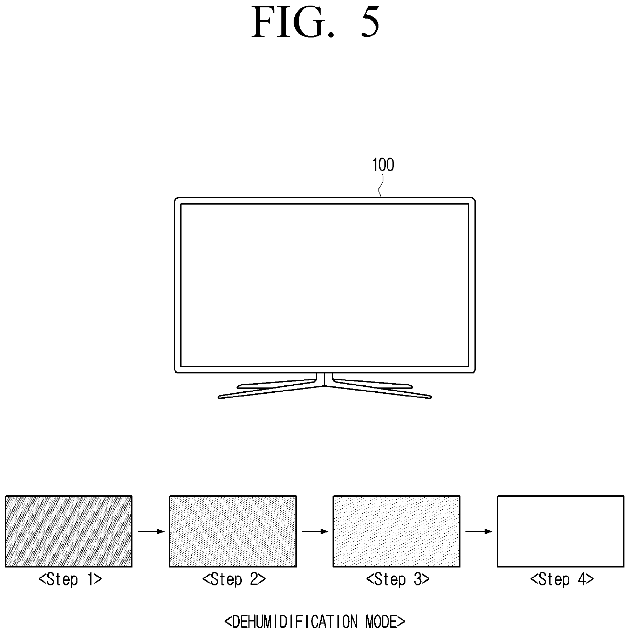

The plurality of predetermined images according to an embodiment of the disclosure will be explained with reference to FIG. 5.

FIG. 5 is a diagram for illustrating a plurality of predetermined images according to an embodiment of the disclosure.

The dehumidification mode according to an embodiment may be a mode wherein the display 120 sequentially provides each of the plurality of predetermined images during a specific time.

For example, as illustrated in FIG. 5, in Step 1 of the dehumidification mode of the display device 100, the sub processor 132 may control the display 120 to display an image corresponding to the lowest luminance among the plurality of predetermined images during a specific time.

Then, in Step 2 of the dehumidification mode of the display device 100, the sub processor 132 may control the display 120 to display an image corresponding to luminance that is relatively higher than that of the image displayed in Step 1 among the plurality of predetermined images during the specific time.

Referring to FIG. 5, the sub processor 132 may sequentially display each of the plurality of predetermined images during the specific time, such that the luminance of the screen displayed by the display 120 gradually increases.

For example, in case the display 120 was exposed to a humid environment for a long time, if the display 120 displays an image or a general content of high luminance abruptly (or, without executing the dehumidification mode), a high current is applied to the LEDs provided in the display 120, and thus physical damage (e.g., a metal migration phenomenon between an anode and a cathode) may occur in the LEDs.

If a control instruction for executing the dehumidification mode is received while the display device 100 is displaying a general content after it was switched from the standby mode to the general mode (e.g., after booting of the display device 100 was completed), the display 120 displays an image of high luminance included in the general content before executing the dehumidification mode, and thus physical damage may occur in the LEDs.

In contrast, the display device 100 according to an embodiment of the disclosure is not switched to the dehumidification mode after it is switched from the standby mode to the general mode (the standby mode -> the general mode -> the dehumidification mode), but directly executes the dehumidification mode in the standby mode (the standby mode -> the dehumidification mode), and thus the display device 100 may execute the dehumidification mode without a process of displaying an image of high luminance, and can thereby prevent physical damage that may occur in case an unexpected high current is applied to the LEDs.

For example, as illustrated in FIG. 5, if the display device 100 sequentially displays images corresponding to each of a plurality of steps (e.g., Step 1 to Step 4) according to the dehumidification mode, the luminance of the screen displayed by the display 120 may sequentially increase from low luminance to high luminance, and a current applied to the LEDs may sequentially increase from a low current to a high current. Accordingly, a situation wherein an unintended high current is applied to the LEDs that were exposed to a hot and humid environment for a long time can be prevented beforehand.

FIG. 5 was illustrated based on the assumption of a case wherein the luminance of each of the plurality of predetermined images is different, for the convenience of explanation, but this is merely an example, and the disclosure is obviously not limited thereto.

For example, each of the plurality of predetermined images may be an image wherein at least one of the pattern, the luminance, or the color is different.

If the display device 100 is switched to the dehumidification mode, the sub processor 132 according to an embodiment of the disclosure may sequentially display each of the plurality of predetermined images during the specific time such that a current applied to the LEDs sequentially increases from a low current to a high current.

Meanwhile, it is obvious that information on the order of display among the plurality of predetermined images can be stored in advance in the memory (not shown), and the sub processor 132 can identify the information on the order of display among the plurality of predetermined images such that a current applied to the LEDs sequentially increases from a low current to a high current.

However, the dehumidification mode wherein the display device 100 sequentially displays images corresponding to each of the plurality of steps (e.g., Step 1 to Step 4) as illustrated in FIG. 5 is merely an example, and the disclosure is not limited thereto. For example, the sub processor 132 can obviously apply a current smaller than the threshold value to the LEDs during the specific time in the dehumidification mode.

According to an embodiment of the disclosure, when the display device 100 executes the dehumidification mode, heat may be generated in the display 120, or the LEDs provided in the display 120, and the air around the display device 100 or the LEDs may be changed from a humid environment to a dry environment.

In case the LEDs are exposed to a dry environment, physical damage (e.g., a metal migration phenomenon between an anode and a cathode) may not occur in the LEDs even if a high current is applied to the LEDs.

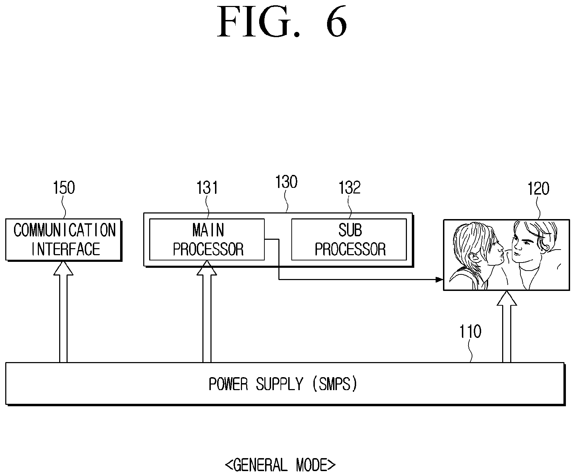

The general mode according to an embodiment of the disclosure will be explained with reference to FIG. 6.

FIG. 6 is a diagram for illustrating a general mode according to an embodiment of the disclosure.

Referring to FIG. 6, the power supply 110 may supply power to the main processor 131 provided in the display device 100 in the general mode.

According to an embodiment, if the display device 100 is switched from the standby mode or the dehumidification mode to the general mode, the main processor 131 may receive power through the power supply 110. Also, the main processor 131 may control the display 120 to display a screen corresponding to an image signal received through the communication interface 150.

The display device 100 according to an embodiment of the disclosure may not supply power to the main processor 131 that processes an image signal received from an external device (e.g., a source device, an external server, etc.) in the dehumidification mode, but supply power only to the sub processor 132 such that a current applied to the LEDs included in the display 120 sequentially increases from a low current to a high current, or a current smaller than the threshold value is applied.

In contrast, the display device 100 may process an image signal received from an external device (e.g., a source device, an external server, etc.) in the general mode, and then supply power to the main processor 131 that controls the display 120 to display a screen corresponding to the image signal.

FIG. 6 was illustrated based on the assumption of a case wherein the power supply 110 supplies power to the main processor 131 and the display 120, for the convenience of explanation, but the configuration illustrated in FIG. 6 does not mean a configuration wherein the power supply 110 does not supply power to the various components provided in the display device 100 such as the sub processor 132, the sensor 140, the communication interface 150, etc.

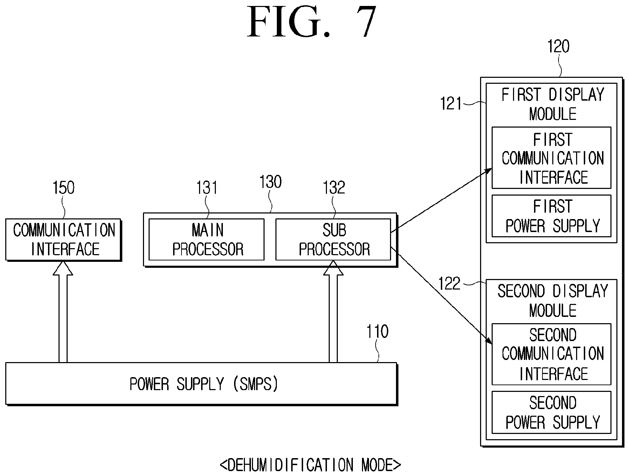

FIG. 7 is a diagram for illustrating a dehumidification mode according to another embodiment of the disclosure.

FIG. 1 to FIG. 6 were illustrated based on the assumption of a configuration wherein the sub processor 132 supplies power to the display 120 by controlling the power supply 110 when the display device 100 is switched to the dehumidification mode, but the disclosure is obviously not limited thereto.

As an example, the display 120 may be divided into a plurality of display modules, and each of the plurality of display modules may include a communication interface, a power supply, and a controller.

When the display device 100 is switched from the standby mode to the dehumidification mode, the sub processor 132 according to an embodiment may transmit a control signal to the first communication interface provided in the first display module 121 among the plurality of display modules. Here, the control signal may be a signal for performing control such that the controller provided in the first display module 121 supplies power to the LEDs provided in the first display module 121 by controlling the first power supply, and the first display module 121 displays each of the plurality of predetermined images.

Also, when the display device 100 is switched from the standby mode to the dehumidification mode, the sub processor 132 may transmit a control signal to the second communication interface provided in the second display module 122 among the plurality of display modules. Here, the control signal may be a signal for performing control such that the controller provided in the second display module 122 supplies power to the LEDs provided in the second display module 122 by controlling the second power supply, and the second display module 122 displays each of the plurality of predetermined images.

As described above, in case the display 120 includes a plurality of display modules, and each of the plurality of display modules includes a separate power supply, a separate controller, etc., if the display device 100 is switched from the standby mode to the dehumidification mode, the sub processor 132 provided in the display device 100 may transmit a control signal for switching each of the plurality of display modules to the dehumidification mode to each of the plurality of display modules.

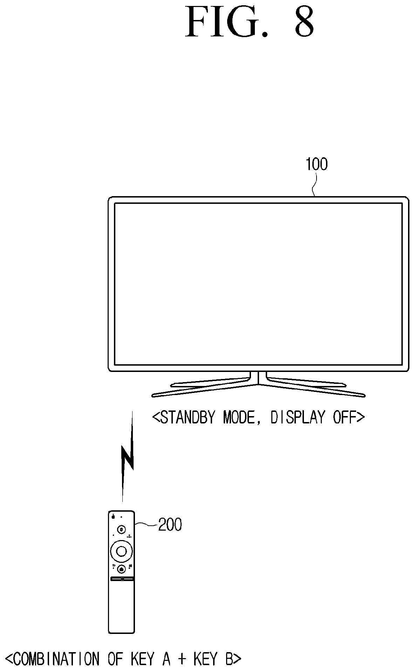

FIG. 8 is a diagram for illustrating a control instruction according to an embodiment of the disclosure.

In FIG. 1 to FIG. 6, embodiments wherein the display device 100 automatically executes the dehumidification mode based on the humidity information detected by the sensor 140 were explained, but the display device 100 can obviously execute the dehumidification mode by receiving a control instruction from an external device.

According to an embodiment, when a control instruction is received from the remote control device 200 through the communication interface 150 while the display device 100 is in the standby mode, the sub processor 132 may switch the display device 100 from the standby mode to the dehumidification mode according to the control instruction.

A control instruction according to an embodiment may be an instruction for switching the display device 100 from the standby mode to the dehumidification mode.

For example, if at least two buttons among the plurality of buttons provided in the remote control device 200 are pushed, the remote control device 200 may obtain a control instruction for switching the display device 100 from the standby mode to the dehumidification mode, and transmit the control instruction to the display device 100.

As illustrated in FIG. 8, according to a push operation (a Hotkey) wherein the button A and the button B are combined among the plurality of buttons provided on the remote control device 200, the remote control device 200 may obtain a control instruction, and transmit the control instruction to the display device 100.

However, this is merely an example, and the remote control device 200 may include a specific button that can obtain a control instruction for switching the display device 100 from the standby mode to the dehumidification mode, and when the specific button is pushed but not at least two buttons, the remote control device 200 may transmit the control instruction to the display device 100.

As another example, the display device 100 may execute the dehumidification mode when predetermined conditions are satisfied.

As an example, if the standby mode of the display device 100 is maintained for greater than or equal to a threshold time, the sub processor 132 may switch the display device 100 from the standby mode to the dehumidification mode. For example, if the standby mode of the display device 100 is maintained during one week, the sub processor 132 may switch the display device 100 from the standby mode to the dehumidification mode.

As another example, if a predetermined time passes (e.g., six months pass) after shipping of the display device 100 (e.g., a time point of shipping from the manufacturer, a time point of installation of the display device 100, etc.), the display device 100 may automatically execute the dehumidification mode.

As still another example, if the predetermined time passes (e.g., six months pass) after the display device 100 executed the dehumidification mode shortly beforehand, the display device 100 may automatically execute the dehumidification mode.

As still another example, if the environment around the location wherein the display device 100 is arranged, and the temperature and the humidity of the ambient air satisfy the predetermined conditions, the display device 100 may automatically execute the dehumidification mode. For example, if the temperature and the humidity of the environment around the location wherein the display device 100 is arranged satisfy at least one of 40°C or higher or 80%RH or higher, the display device 100 may automatically execute the dehumidification mode.

However, the disclosure is not limited to the aforementioned examples, and the specific numbers are merely examples for the convenience of explanation, and can obviously be changed according to the setting of the user, the setting of the manufacturer, etc. Also, if it is determined that the LEDs provided in the display 120 were exposed to a hot and humid environment for a long time through various methods, the display device 100 can obviously execute the dehumidification mode automatically.

The sub processor 132 according to an embodiment of the disclosure may obtain humidity information through the sensor 140 while the display device 100 is in the dehumidification mode. Then, if it is identified that the humidity of the ambient air is smaller than the threshold value based on the humidity information obtained while the display device 100 is in the dehumidification mode, the sub processor 132 may control the power supply 110 such that power is not supplied to the display 120 by switching the display device 100 from the dehumidification mode to the standby mode.

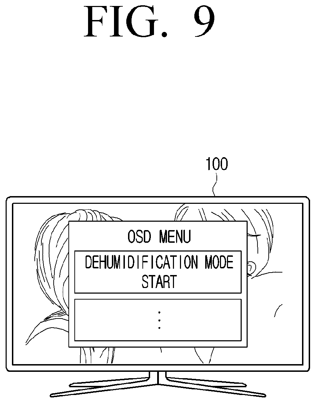

FIG. 9 is a diagram for illustrating an OSD menu according to an embodiment of the disclosure.

According to an embodiment of the disclosure, while the display device 100 displays a screen corresponding to an image signal (e.g., a content screen) in the general mode, the main processor 131 may display an OSD menu.

The OSD menu according to an embodiment may include a menu for executing the dehumidification mode, and if the menu for executing the dehumidification mode is selected according to a user instruction, the main processor 131 may switch the display device 100 from the general mode to the dehumidification mode.

Meanwhile, the display device 100 according to an embodiment of the disclosure discloses a method for being switched from the standby mode to the dehumidification mode (i.e., a method for executing the dehumidification mode without going through the general mode) other than a method for being switched from the general mode to the dehumidification mode.

According to an embodiment, if the main processor 131 processes an image signal in the general mode, and controls the display 120 to display a screen corresponding to the image signal, a high current is applied to the LEDs as the display 120 displays a screen of high luminance, and thus damage may occur in the LEDs.

According to an embodiment of the disclosure, if the sub processor 132 controls the display device 100 to be switched from the standby mode to the dehumidification mode without going through the general mode, a high current may not be applied to the LEDs, and the display 120 may sequentially display the plurality of predetermined images according to the dehumidification mode.

If the display device 100 is switched from the standby mode or the dehumidification mode to the general mode after finishing the dehumidification mode, damage may not occur in the LEDs even if the main processor 131 processes an image signal and controls the display 120 to display a screen corresponding to the image signal.

Meanwhile, while the display 120 displays the plurality of predetermined images in the dehumidification mode according to an embodiment of the disclosure, if a control instruction for switching the display device 100 to the general mode is received from the remote control device 200 through the communication interface 150, the main processor 131 may switch the display device 100 from the dehumidification mode to the general mode.

Returning to FIG. 2, the communication interface 150 according to an embodiment of the disclosure may perform communication with an external device, or the plurality of display modules provided in the display 120 by a wired communication method. For example, the communication interface 150 may use a high definition multimedia interface (HDMI) cable, a low voltage differential signals (LVDS) cable, a digital visual interface (DVI) cable, a D-subminiature (D-SUB) cable, a video graphics array (VGA) cable, or an optical cable, etc.

According to another embodiment, the communication interface 150 may perform communication with an external device, or the plurality of display modules provided in the display 120 by a wireless communication method. For example, the communication interface 150 may include a Wi-Fi module (not shown), a Bluetooth module (not shown), an infrared (IR) module, a local area network (LAN) module, an Ethernet module, etc. Here, each communication module may be implemented in a form of at least one hardware chip. A wireless communication module may include at least one communication chip that performs communication according to various wireless communication standards such as Zigbee, a Universal Serial Bus (USB), a Mobile Industry Processor Interface Camera Serial Interface (MIPI CSI), 3rd Generation (3G), 3rd Generation Partnership Project (3GPP), Long Term Evolution (LTE), LTEAdvanced (LTE-A), 4th Generation (4G), 5th Generation (5G), etc. other than the aforementioned communication methods. However, this is merely an example, and the communication interface 150 may use at least one communication module among various communication modules.

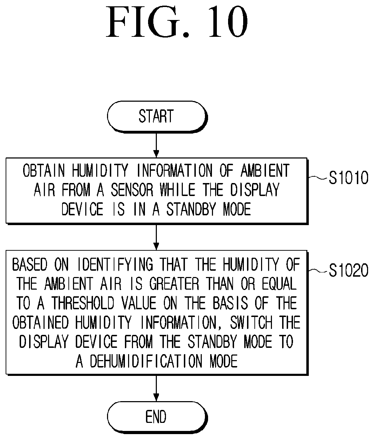

FIG. 10 is a flow chart for illustrating a control method of a display device according to an embodiment of the disclosure.

According to an embodiment of the disclosure for achieving the aforementioned purpose, in a control method of a display device, first, humidity information of ambient air is obtained from a sensor while the display device is in a standby mode in operation S1010.

Then, if it is identified that the humidity of the ambient air is greater than or equal to a threshold value on the basis of the obtained humidity information, the display device is switched from the standby mode to a dehumidification mode in operation S 1020.

Here, the switching operation S1020 includes the steps of, based on the display device being switched to the dehumidification mode, supplying power to a display provided in the display device, and controlling the display to sequentially display each of a plurality of predetermined images during a specific time.

Here, the display device may include a main processor and a sub processor, and the switching operation S1020 may include the step of, based on the sub processor supplied with power in the standby mode identifying that the humidity of the ambient air is greater than or equal to a threshold value, switching the display device from the standby mode to the dehumidification mode. Also, the control method according to an embodiment of the disclosure may further include the steps of, based on the display device being switched from the standby mode or the dehumidification mode to a general mode, the main processor being supplied with power, and the main processor controlling the display to display a screen corresponding to a received image signal.

Also, the switching operation S 1020 may include the step of, based on receiving a control instruction from a remote control device while the display device is in the standby mode, switching the display device from the standby mode to the dehumidification mode according to the control instruction.

Here, the control instruction may be a control instruction received from the remote control device as at least two buttons among a plurality of buttons provided on the remote control device are pushed.

Also, the control method according to an embodiment of the disclosure may further include the steps of obtaining humidity information while the display device is in the dehumidification mode, and based on identifying that the humidity of the ambient air is smaller than the threshold value on the basis of the humidity information obtained while the display device is in the dehumidification mode, controlling such that power is not supplied to the display by switching the display device from the dehumidification mode to the standby mode.

The control method according to an embodiment of the disclosure may further include the step of, based on the standby mode of the display device being maintained for greater than or equal to a threshold time, switching the display device from the standby mode to the dehumidification mode.

Also, the sensor may include any one of a humidity detection sensor provided in the display device or a humidity detection sensor provided in the external device.

In addition, the control method according to an embodiment of the disclosure may further include the step of, based on receiving a control instruction for switching the display device to a general mode from a remote control device while the display displays the plurality of predetermined images in the dehumidification mode, switching the display device from the dehumidification mode to the general mode.

Further, each of the plurality of predetermined images may be an image wherein at least one of a pattern of the image, luminance of the image, or a color of the image is different, and the switching operation S 1020 may include the step of controlling the display to sequentially display each of the plurality of predetermined images during the specific time such that the luminance of a screen displayed by the display gradually increases.

Also, the display may include a plurality of display modules, and a first display module among the plurality of display modules may include a first communication interface and a first power supply, and a second display module among the plurality of display modules may include a second communication interface and a second power supply. In addition, the switching operation S 1020 may include the steps of, based on the display device being switched to the dehumidification mode, controlling the first power supply to supply power to the first display module by transmitting a control signal for switching the first display module to the dehumidification mode to the first communication interface, and controlling the second power supply to supply power to the second display module by transmitting a control signal for switching the second display module to the dehumidification mode to the second communication interface.

Meanwhile, the various embodiments of the disclosure can not only be applied to an electronic device according to an embodiment of the disclosure, but also to all types of electronic devices including a display.

Meanwhile, the aforementioned various embodiments may be implemented in a recording medium that can be read by a computer or a device similar to a computer, by using software, hardware, or a combination thereof. In some cases, the embodiments described in this specification may be implemented as a processor itself. According to implementation by software, the embodiments such as processes and functions described in this specification may be implemented as separate software modules. Each of the software modules can perform one or more functions and operations described in this specification.

Meanwhile, computer instructions for performing processing operations of an electronic device according to the aforementioned various embodiments of the disclosure may be stored in a non-transitory computer-readable medium. Computer instructions stored in such a non-transitory computer-readable medium make the processing operations at the electronic device 100 according to the aforementioned various embodiments performed by a specific machine, when the instructions are executed by the processor of the specific machine.

A non-transitory computer-readable medium refers to a medium that stores data semi-permanently, and is readable by machines, but not a medium that stores data for a short moment such as a register, a cache, and memory. As specific examples of a non-transitory computer-readable medium, there may be a CD, a DVD, a hard disc, a blue-ray disc, a USB, a memory card, ROM, and the like.

While preferred embodiments of the disclosure have been shown and described, the disclosure is not limited to the aforementioned specific embodiments, and it is apparent that various modifications may be made by those having ordinary skill in the technical field to which the disclosure belongs, without departing from the gist of the disclosure as claimed by the appended claims. Further, it is intended that such modifications are not to be interpreted independently from the technical idea or prospect of the disclosure.

## Claims

1. A display device comprising:
a power supply;
a display;
a communication interface including circuitry; and
at least one processor configured to:
obtain humidity information of ambient air from a sensor, or receive the humidity information from an external device through the communication interface while the display device is in a standby mode, and
based on identifying that the humidity of the ambient air is greater than or equal to a threshold value on the basis of the obtained humidity information, switch the display device from the standby mode to a dehumidification mode,
wherein the at least one processor is configured to:
based on the display device being switched to the dehumidification mode, control the power supply to supply power to the display, and control the display to sequentially display each of a plurality of predetermined images during a specific time.

2. The display device of claim 1,
wherein the at least one processor comprises:
a main processor and a sub processor, and
the sub processor is configured to:
receive power through the power supply in the standby mode, and based on identifying that the humidity of the ambient air is greater than or equal to the threshold value, switch the display device to the dehumidification mode, and
the main processor is configured to:
based on the display device being switched from the standby mode or the dehumidification mode to a general mode, receive power through the power supply, and control the display to display a screen corresponding to an image signal received through the communication interface.

3. The display device of claim 1,
wherein the at least one processor is configured to:
based on receiving a control instruction from a remote control device through the communication interface while the display device is in the standby mode, switch the display device from the standby mode to the dehumidification mode according to the control instruction.

4. The display device of claim 3,
wherein the control instruction is a control instruction received from the remote control device as at least two buttons among a plurality of buttons provided on the remote control device are pushed.

5. The display device of claim 1,
wherein the at least one processor is configured to:
obtain humidity information while the display device is in the dehumidification mode, and
based on identifying that the humidity of the ambient air is smaller than the threshold value on the basis of the humidity information obtained while the display device is in the dehumidification mode, control the power supply such that power is not supplied to the display by switching the display device from the dehumidification mode to the standby mode.

6. The display device of claim 1,
wherein the at least one processor is configured to:
based on the standby mode of the display device being maintained for greater than or equal to a threshold time, switch the display device from the standby mode to the dehumidification mode.

7. The display device of claim 1,
wherein the sensor comprises:
any one of a humidity detection sensor provided in the display device or a humidity detection sensor provided in the external device.

8. The display device of claim 1,
wherein the at least one processor is configured to:
based on receiving a control instruction for switching the display device to a general mode from a remote control device through the communication interface while the display displays the plurality of predetermined images in the dehumidification mode, switch the display device from the dehumidification mode to the general mode.

9. The display device of claim 1,
wherein each of the plurality of predetermined images is an image wherein at least one of a pattern of the image, luminance of the image, or a color of the image is different, and
the at least one processor is configured to:
control the display to sequentially display each of the plurality of predetermined images during the specific time such that the luminance of a screen displayed by the display gradually increases.

10. The display device of claim 1,
wherein the display includes a plurality of display modules, and
a first display module among the plurality of display modules includes a first communication interface and a first power supply, and
a second display module among the plurality of display modules includes a second communication interface and a second power supply, and
the at least one processor is configured to:
based on the display device being switched to the dehumidification mode, control the first power supply to supply power to the first display module by transmitting a control signal for switching the first display module to the dehumidification mode to the first communication interface, and
control the second power supply to supply power to the second display module by transmitting a control signal for switching the second display module to the dehumidification mode to the second communication interface.

11. A control method of a display device, the method comprising:
obtaining humidity information of ambient air from a sensor while the display device is in a standby mode; and
based on identifying that the humidity of the ambient air is greater than or equal to a threshold value on the basis of the obtained humidity information, switching the display device from the standby mode to a dehumidification mode,
wherein the switching comprises:
based on the display device being switched to the dehumidification mode, supplying power to a display provided in the display device; and
controlling the display to sequentially display each of a plurality of predetermined images during a specific time.

12. The control method of claim 11,
wherein the display device comprises a main processor and a sub processor, and
the switching comprises:
based on the sub processor supplied with power in the standby mode identifying that the humidity of the ambient air is greater than or equal to a threshold value, switching the display device from the standby mode to the dehumidification mode, and
the control method further comprises:
based on the display device being switched from the standby mode or the dehumidification mode to a general mode, the main processor being supplied with power; and
the main processor controlling the display to display a screen corresponding to a received image signal.

13. The control method of claim 11,
wherein the switching comprises:
based on receiving a control instruction from a remote control device while the display device is in the standby mode, switching the display device from the standby mode to the dehumidification mode according to the control instruction.

14. The control method of claim 13,
wherein the control instruction is a control instruction received from the remote control device as at least two buttons among a plurality of buttons provided on the remote control device are pushed.

15. The control method of claim 11,
wherein the control method further comprises:
obtaining humidity information while the display device is in the dehumidification mode; and
based on identifying that the humidity of the ambient air is smaller than the threshold value on the basis of the humidity information obtained while the display device is in the dehumidification mode, controlling such that power is not supplied to the display by switching the display device from the dehumidification mode to the standby mode.
